# EUROPEAN PATENT APPLICATION

(11) **EP 4 697 597 A2**
(43) Date of publication of application: **18.02.2026**
(21) Application number: 25220848.3
(22) Date of filing: 19.09.2022
(51) Int. Cl.: H03F 3/45

(54) **COMPARATOR ARCHITECTURE SUPPORTING LOWER OXIDE BREAKDOWN VOLTAGES**

(30) Priority: 23.09.2021 US 202163247348 P; 24.02.2022 US 202217679978
(62) Divisional of application: 22787074.8
(71) Applicant: Texas Instruments Incorporated, Dallas, TX 75265 (US)
(72) Inventor: ELIES, Brian Roger, Dallas, TX 75204 (US)
(74) Representative: Zeller, Andreas

(57) **Abstract**

A circuit (100) includes a transistor input pair (114, 153), a differential input having a comparator input (102, 104), and a level shifter (116, 157). The transistor input pair (114, 153) is adapted to be coupled between a voltage supply and a comparator output (106, 108). The transistor input pair (114, 153) includes a first transistor having a gate and a drain. The drain of the first transistor is coupled to the comparator output (106, 108). The level shifter (116, 157) is coupled between the transistor input pair (114, 153) and the differential input. The level shifter (116, 157) includes a second transistor having a gate and a source. The gate of the second transistor is coupled to the comparator input (102, 104). The source of the second transistor is coupled to the gate of the first transistor.

## Description

### BACKGROUND

A comparator is a circuit, component, or device that provides an output having a state indicative of a comparison between input voltages. The output provided by the comparator can have a first state (e.g., a high state) responsive to a first input voltage exceeding a second input voltage. The output provided by the comparator can have a second state (e.g., a low state) responsive to the second input voltage exceeding the first input voltage. Comparators can be formed using transistors and other semiconductor devices. Process node scaling for improving circuit speed, power efficiency, and other benefits can involve reducing a number of device feature sizes such as the gate oxide thickness of a transistor. Reducing gate oxide thickness of transistors forming a comparator can reduce a common mode input range (CMIR) that the comparator can support.

### SUMMARY

In accordance with at least one example of the description, a circuit includes a transistor input pair, a differential input having a comparator input, and a level shifter. The transistor input pair is adapted to be coupled between a voltage supply and a comparator output. The transistor input pair includes a first transistor having a gate and a drain. The drain of the first transistor is coupled to the comparator output. The level shifter is coupled between the transistor input pair and the differential input. The level shifter includes a second transistor having a gate and a source. The gate of the second transistor is coupled to the comparator input. The source of the second transistor is coupled to the gate of the first transistor.

In accordance with at least one example of the description, a circuit includes a transistor input pair and a body bias controller. The transistor input pair is adapted to be coupled between a voltage supply and a comparator output. The transistor input pair includes a first transistor having a body, a source, and a drain. The drain of the first transistor is coupled to the comparator output. The body bias controller includes a body bias interface and a second transistor having a gate and a source. The body bias interface is coupled to the body of the first transistor and the source of the second transistor. The gate of the second transistor is coupled to the source of the first transistor

In accordance with at least one example of the description, a circuit includes a transistor input pair, a level shifter, and a body bias controller. The transistor input pair is adapted to be coupled between a voltage supply and a comparator output. The transistor input pair includes a first transistor having a gate, a body, and a source. The level shifter is coupled between the transistor input pair and a differential input having a comparator input. The level shifter includes a second transistor having a gate and a source. The gate of the second transistor is coupled to the comparator input. The source of the second transistor is coupled to the gate of the first transistor. The body bias controller includes a body bias interface and a third transistor having a gate and a source. The body bias interface is coupled to the body of the first transistor and the source of the third transistor. The gate of the third transistor is coupled to the source of the first transistor.
The invention also covers the following:
1. A circuit, comprising:
   a transistor input pair adapted to be coupled between a voltage supply and a comparator output, the transistor input pair including a first transistor having a gate and a drain, wherein the drain of the first transistor is coupled to the comparator output;
   a differential input having a comparator input; and
   a level shifter coupled between the transistor input pair and the differential input, the level shifter including a second transistor having a gate and a source, wherein the gate of the second transistor is coupled to the comparator input, and the source of the second transistor is coupled to the gate of the first transistor.
2. The circuit of item 1, further comprising:
   an active load circuit that is coupled between the transistor input pair and ground.
3. The circuit of item 1, wherein the level shifter further includes a third transistor having a gate and a source, the gate of the third transistor is coupled to the comparator input, and the source of the third transistor is coupled to the gate of the second transistor.
4. The circuit of item 1, wherein the transistor input pair is a first transistor input pair, the circuit further comprising:
   a second transistor input pair that is coupled between the voltage supply and the comparator output, the second transistor input pair including a third transistor having a drain that is coupled to the comparator output.
5. The circuit of item 4, further comprising:
   a clamp circuit that includes a fourth transistor having a source that is coupled to a gate of the third transistor.
6. The circuit of item 4, wherein the level shifter is a first level shifter, the circuit further comprising:
   a second level shifter that is coupled between the second transistor input pair and the differential input, the second level shifter including a fourth transistor having a source that is coupled to the gate of the third transistor.
7. The circuit of item 1, wherein the transistor input pair further includes a third transistor and the level shifter further includes a fourth transistor, the third transistor having a source and a gate, the source of the third transistor is coupled to the source of the first transistor, and the fourth transistor having a source that is coupled to the gate of the third transistor.
8. The circuit of item 1, wherein the level shifter further includes a resistor having a first terminal and a second terminal, the first terminal of the resistor is coupled to the source of the second transistor and the gate of the first transistor, and the second terminal of the resistor is coupled to ground.
9. A circuit, comprising:
   a transistor input pair adapted to be coupled between a voltage supply and a comparator output, the transistor input pair including a first transistor having a body, a source, and a drain, wherein the drain of the first transistor is coupled to the comparator output; and
   a body bias controller including a body bias interface and a second transistor having a gate and a source, wherein the body bias interface is coupled to the body of the first transistor and the source of the second transistor, and the gate of the second transistor is coupled to the source of the first transistor.
10. The circuit of item 9, further comprising:
   a differential input coupled to the transistor input pair, wherein the body bias controller is configured to control a voltage provided at the body bias interface based on a common mode input voltage of a differential input signal provided at the differential input.
11. The circuit of item 10, wherein the transistor input pair is a first transistor input pair, the body bias interface is a first body bias interface, the body bias controller further includes a second body bias interface, the circuit further comprising:
   a second transistor input pair that is coupled between the voltage supply and the comparator output, the second transistor input pair including a third transistor having a body that is coupled to the second body bias interface, wherein the body bias controller is further configured to control a voltage provided at the second body bias interface based on the common mode input voltage of the differential input signal.
12. The circuit of item 10, wherein the body bias controller is further configured to dynamically adjust the voltage provided at the body bias interface in a manner that tracks common mode input voltage variations of the differential input signal.
13. The circuit of item 9, wherein the transistor input pair further includes a third transistor having a body and a source, the body of the third transistor is coupled to the body bias interface, and the source of the third transistor is coupled to the gate of the second transistor.
14. The circuit of item 9, further comprising:
   a clamp circuit that includes a third transistor having a source that is coupled to a gate of the first transistor.
15. The circuit of item 9, wherein the first transistor is a p-channel field-effect transistor.
16. A circuit, comprising:
   a transistor input pair adapted to be coupled between a voltage supply and a comparator output, the transistor input pair including a first transistor having a gate, a body, and a source;
   a level shifter coupled between the transistor input pair and a differential input having a comparator input, the level shifter including a second transistor having a gate and a source, wherein the gate of the second transistor is coupled to the comparator input, and the source of the second transistor is coupled to the gate of the first transistor; and
   a body bias controller including a body bias interface and a third transistor having a gate and a source, wherein the body bias interface is coupled to the body of the first transistor and the source of the third transistor, and the gate of the third transistor is coupled to the source of the first transistor.
17. The circuit of item 16, wherein the body bias controller is configured to control a voltage provided at the body bias interface based on a common mode input voltage of a differential input signal provided at the differential input.
18. The circuit of item 17, wherein the transistor input pair is a first transistor input pair, the body bias interface is a first body bias interface, the body bias controller further includes a second body bias interface, the circuit further comprising:
   a second transistor input pair that is coupled between the voltage supply and the comparator output, the second transistor input pair including a fourth transistor having a body that is coupled to the second body bias interface, wherein the body bias controller is further configured to control a voltage provided at the second body bias interface based on the common mode input voltage of the differential input signal.
19. The circuit of item 16, further comprising:
   a clamp circuit that includes a fourth transistor having a source that is coupled to the gate of the first transistor.
20. The circuit of item 16, wherein a drain of the second transistor is adapted to be coupled to ground.

### BRIEF DESCRIPTION OF THE DRAWINGS

FIG. 1 is a schematic diagram of an example comparator.
FIG. 2 is a schematic diagram of an example implementation of a high-side input circuit.
FIG. 3 is a schematic diagram of an example clamp driver circuit.
FIG. 4 is a diagram of an example degradation or stress event that can negatively impact performance and/or reliability of semiconductor devices.
FIG. 5 is a diagram of another example degradation or stress event that can negatively impact performance and/or reliability of semiconductor devices.
FIG. 6 is a schematic diagram of an example implementation of a high-side input circuit.
FIG. 7 is a schematic diagram of an example body bias controller.
FIG. 8 is a block diagram of an example system that includes the comparator.

### DETAILED DESCRIPTION OF EXAMPLE EMBODIMENTS

As described above, process node scaling for improving circuit speed, power efficiency, and other benefits can reduce gate oxide thickness of transistors forming a comparator. Such gate oxide reduction can reduce an input voltage range and/or a common mode input range (CMIR) that a comparator can support. For example, reducing gate oxide thickness of transistors forming a comparator can lower an oxide breakdown voltage (V_{bd}) of one or more of the transistors. In some instances, input signals provided to a comparator formed by transistors with reduced gate oxide thickness can include a common mode component or a common mode input voltage (V_{cm}) that exceeds V_{bd} of one or more of the transistors. Exceeding the V_{bd} of one or more of the transistors can stress or permanently damage gate oxide material of the transistors, thereby degrading operation of the comparator.

Some existing comparator architectures may expand an input voltage range and/or a CMIR of a comparator with lower oxide breakdown voltages using an external resistor divider. The external resistor divider may be coupled between a source providing input signals and a comparator input. The external resistor divider may scale the input signals to avoid exceeding the lower oxide breakdown voltages. Other existing comparator architectures may expand an input voltage range and/or a CMIR of a comparator with lower oxide breakdown voltages using an external operational amplifier (op-amp) voltage buffer. The external op-amp voltage buffer may be coupled between a source providing input signals and a comparator input. The external op-amp voltage buffer may also scale the input signals to avoid exceeding the lower oxide breakdown voltages. While effective, adding external components (e.g., the external resistor divider and/or the external op-amp voltage buffer) to provide a comparator with a wide input voltage range and/or CMIR while supporting lower oxide breakdown voltages increases both component costs and system size. Such external components may also compromise comparator performance. For example, the external resistor divider and/or the external op-amp voltage buffer may lower an input impedance of the comparator input to an unacceptable level, increase a response time of the comparator by increasing input latency, introduce noise into the input signals, and/or consume additional power.

Aspects of this description relate to a comparator having a wide input voltage range and/or CMIR while supporting lower oxide breakdown voltages. In at least one example, the comparator includes a level shifter coupled between a differential input and a transistor input pair. The level shifter can be configured to reduce gate-to-source voltage (V_{gs}) values within the input pair to facilitate mitigating gate oxide stress. To that end, the level shifter can be configured to apply a voltage shift to a differential input signal provided at the differential input to create a shifted differential input signal for driving the input pair. In various examples, the voltage shift can be proportional to a threshold voltage (Vt) of a transistor (e.g., +Vₜ and/or - Vₜ). While proportional to the differential input signal, a voltage level of the shifted differential input signal can be less than a voltage level of the differential input signal. Accordingly, the level shifter avoids exceeding the lower oxide breakdown voltages without adding external components. In various examples, internal components (e.g., components forming the level shifter) can be added to the comparator to facilitate supporting lower oxide breakdown voltages. Such internal components can be smaller in size relative to the external components described above and/or be provided on-die with the comparator. As such, components cost and/or system size increases associated adding such internal components can be minimal. Component cost and system size increases associated with the external components described above can be avoided.

In at least one example, the comparator can include a body bias controller having a body bias interface that facilitates implementing body bias control within the input pair. The body bias controller can be configured to control a voltage provided at the body bias interface based on a common mode input voltage of a differential input signal provided at the differential input. The body bias controller can be further configured to dynamically adjust the voltage provided at the body bias interface in a manner that tracks input voltage variations of the differential input signal. The body bias controller can be useful to mitigate bias temperature instability (BTI)-induced aging, gate oxide stress, and/or other negative impacts related to degradation or stress events within the input pair without compromising performance of the comparator.

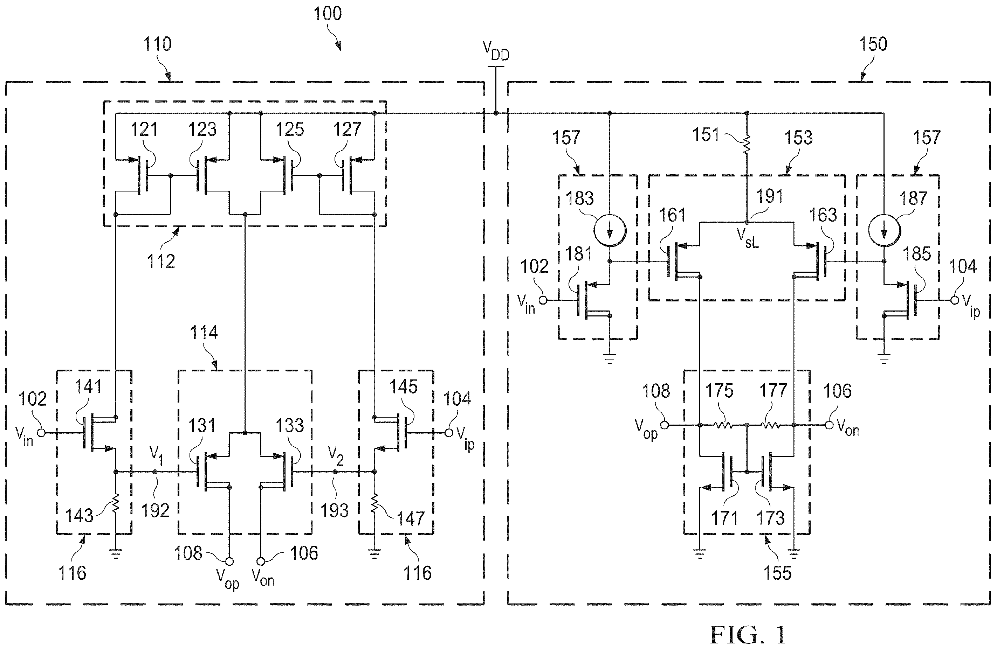

FIG. 1 is a schematic diagram of an example comparator 100. At least some implementations of the comparator 100 are representative of an architecture that supports lower oxide breakdown voltages for transistors or other switching devices, such as field-effect transistors (FETs), metal-oxide-semiconductor field-effect transistors (MOSFETs), or bipolar junction transistors (BJTs). The comparator 100 can include a first comparator input 102, a second comparator input 104, a first comparator output 106, a second comparator output 108. The first comparator input 102 and the second comparator input 104 can form a differential input of the comparator 100. A voltage (Vᵢₙ) provided at the first comparator input 102 and a voltage (Vᵢₚ) provided at the second comparator input 104 can form a differential input signal. The first comparator output 106 and the second comparator output 108 can form a differential output of the comparator 100. A voltage (Vₒₙ) provided at the first comparator output 106 and a voltage (Vₒₚ) provided at the second comparator output 108 can form a differential output signal.

The comparator 100 can also include a high-side input circuit 110 configured to, responsive to a common mode input voltage (V_{cm}) of the differential input signal exceeding a threshold voltage (Vt) of a transistor, process the differential input signal. V_{cm} can be determined according to (Vᵢₙ + Vᵢₚ)/2. The high-side input circuit 110 can include a bias circuit 112, an input pair 114, and a level shifter 116. The bias circuit 112 can include p-type FETs (PFETs) 121, 123, 125, and 127. The input pair 114 can include PFETs 131 and 133. The level shifter 116 can include an n-type FET (NFET) 141, a resistor 143, an NFET 145, and a resistor 147. While various transistors or other switching devices are illustrated and described with respect to the comparator 100 as PFETs or NFETs, in some examples the comparator 100 may be implemented using NFETs where PFETs are shown and vice versa.

In an example architecture of the high-side input circuit 110, a source of the PFET 121 is coupled to a source of the PFET 123, a source of the PFET 125, a source of the PFET 127, and a voltage (V_{DD}) provided by a voltage supply. A gate of the PFET 121 is coupled to a drain of the PFET 121, a gate of the PFET 123, and a drain of the NFET 141. A drain of the PFET 123 is coupled to a drain of the PFET 125, a source of the PFET 131, and a source of the PFET 133. A gate of the PFET 125 is coupled to a gate of the PFET 127, a drain of the PFET 127, and a drain of the NFET 145. A gate of the PFET 131 is coupled to a source of the NFET 141 and a first terminal of the resistor 143. A drain of the PFET 131 is coupled to the second comparator output 108. A gate of the PFET 133 is coupled to a source of the NFET 145 and a first terminal of the resistor 147. A drain of the PFET 133 is coupled to the first comparator output 106. A gate of the NFET 141 is coupled to the first comparator input 102. A second terminal of the resistor 143 is coupled to ground. A gate of the NFET 145 is coupled to the second comparator input 104. A second terminal of the resistor 147 is coupled to ground.

The comparator 100 can also include a low-side input circuit 150 configured to process the differential input signal with input voltages having a range of values between about 0 volts and V_{DD} - Vₜ. In at least one example, a range of values can exist for V_{cm} in which the high-side input circuit 110 and the low-side input circuit 150 are configured to process the differential input signal. The low-side input circuit 150 can include a resistor 151, an input pair 153, an active load circuit 155, and a level shifter 157. The input pair 153 can include PFETs 161 and 163. The active load circuit 155 can include an NFET 171, an NFET 173, a resistor 175, and a resistor 177. The level shifter 157 can include a PFET 181, a current source 183, a PFET 185, and a current source 187.

In an example architecture of the low-side input circuit 150, a first terminal of the resistor 151 is coupled to V_{DD}. A second terminal of the resistor 151 is coupled to a source of the PFET 161 and a source of the PFET 163. A gate of the PFET 161 is coupled to a source of the PFET 181 and a first terminal of the current source 183. A drain of the PFET 161 is coupled to the second comparator output 108, a drain of the NFET 171, and a first terminal of the resistor 175. A gate of the PFET 163 is coupled to a source of the PFET 185 and a first terminal of the current source 187. A drain of the PFET 163 is coupled to the first comparator output 106, a drain of the NFET 173, and a first terminal of the resistor 177. A source of the NFET 171 is coupled to ground. A gate of the NFET 171 is coupled to a gate of the NFET 173, a second terminal of the resistor 175, and a second terminal of the resistor 177. A source of the NFET 173 is coupled to ground. A gate and a drain of the PFET 181 are coupled to the first comparator input 102 and ground, respectively. A second terminal of the current source 183 is coupled to V_{DD}. A gate and a drain of the PFET 185 are coupled to the second comparator input 104 and ground, respectively. A second terminal of the current source 187 is coupled to V_{DD}.

In at least one example, the comparator 100 can include a drain-extended transistor that can support higher drain voltages than non-drain-extended transistors. For example, FIG. 1 includes a number of drain-extended transistors, such as the PFET 131, the PFET 133, the NFET 141, the NFET 145, the PFET 161, the PFET 163, the PFET 181, and the PFET 185. While various transistors or other switching devices are illustrated and described with respect to the comparator 100 as drain-extended transistors or non-drain-extended transistors, in some examples the comparator 100 may be implemented using drain-extended transistors where non-drain-extended transistors are shown and vice versa.

In operation, the comparator 100 is configured to, responsive to the differential input signal (e.g., Vᵢₙ and Vᵢₚ) provided at the first comparator input 102 and the second comparator input 104, provide the differential output signal (e.g., Vₒₙ and Vₒₚ) at the first comparator output 106 and the second comparator output 108. In at least one example, the comparator 100 is configured to provide the differential output signal asynchronously responsive to the differential input signal provided at the first comparator input 102 and the second comparator input 104. Responsive to Vᵢₙ being greater than Vᵢₚ, the differential output signal provided by the comparator 100 can be in a high state where Vₒₚ is greater than Vₒₙ. Responsive to Vᵢₚ being greater than Vᵢₙ, the differential output signal provided by the comparator 100 can be in a low state where Vₒₙ is greater than Vₒₚ. In at least one example, the first comparator output 106 and the second comparator output 108 are adapted to be coupled to a logic circuit (not shown) that is configured to convert the differential output signal into a digital signal. In this example, the digital signal can assume a high-level (e.g., a logic "1") and a low-level (e.g., a logic "0") when the differential output signal is in the high state and low state, respectively.

Process node scaling can reduce a gate oxide thickness of one or more transistors (e.g., PFETs 131, 133, 161, and/or 163) forming the comparator 100. Reducing the gate oxide thickness can lower a V_{bd} of the one or more transistors forming the comparator 100. In some instances, the lower V_{bd} can reduce a CMIR that the input pair 114 and/or the input pair 153 can support. By way of example, the input pair 153 can be directly driven with a differential input signal. In this example, V_{cm} of the differential input signal can be about 3.3 volts with V_{DD} having a value of about 3.3 volts, Vᵢₙ of the differential input signal having a value of V_{DD}, and Vᵢₚ of the differential input signal having a value of about 0 volts or ground.

Responsive to the input pair 153 being directly driven with the differential input signal, Vᵢₙ having a value of V_{DD} or about 3.3 volts can be provided to the gate of the PFET 161 and Vᵢₚ having a value of about 0 volts can be provided to the gate of the PFET 163. Responsive to V_{DD} or about 3.3 volts and about 0 volts being provided to the gates of the PFET 161 and the PFET 163, respectively, a voltage (V_{sL}) can be provided at a node 191 coupled to the respective sources of PFETs 161 and 163. A value of V_{sL} provided at the node 191 in this example can be determined according to V_{DD}- V_{t,161}, where V_{t,161} is a threshold voltage of the PFET 161. V_{t,161} can be subtracted from V_{DD} by operation of the PFET 161. In that instance, if V_{t,161} is 1 volt, a gate-to-source voltage (V_{gs,163}) of the PFET 163 can be about 2.3 volts. If less than a V_{bd} of gate oxide material forming the PFET 163, the V_{gs,163} of about 2.3 volts can induce stress on the gate oxide material. Permanent damage such as rupturing of the gate oxide material can occur if the V_{gs,163} of about 2.3 volts is greater than or equal to the V_{bd} of the gate oxide material.

The level shifter 116 and the level shifter 157 are configured to reduce V_{gs} values within the input pair 114 and the input pair 153, respectively, to facilitate mitigating such gate oxide stress. To that end, the level shifter 116 and/or the level shifter 157 are configured to apply a voltage shift (e.g., +Vt and/or -Vt) to a differential input signal provided at a differential input of the comparator 100. Applying the fractional gain to the differential input signal can create an attenuated differential input signal for driving the input pair 114 and/or the input pair 153. While proportional to the differential input signal, a voltage level of the attenuated differential input signal can be less than a voltage level of the differential input signal.

In at least one example, the voltage shift of the level shifter 116 and/or the level shifter 157 can be determined according to a number of transistors that are coupled between the differential input and a corresponding input pair in a source follower arrangement. In FIG. 1, level shifters 116 and 157 each include one transistor coupled between the differential input and a corresponding input pair in a source follower arrangement. The NFET 141 is coupled between the first comparator input 102 and the gate of the PFET 131 in a source follower arrangement. The NFET 145 is coupled between the second comparator input 104 and the gate of the PFET 133 in a source follower arrangement. The PFET 181 is coupled between the first comparator input 102 and the gate of the PFET 161 in a source follower arrangement. The PFET 185 is coupled between the second comparator input 104 and the gate of the PFET 163 in a source follower arrangement.

Cascading additional transistors (e.g., 2 and/or 3, etc.) in a source follower arrangement between the differential input and a corresponding input pair can further reduce the voltage level of the shifted differential input signal relative to the differential input signal. For example, the level shifter 116 can include an additional transistor coupled between the first comparator input 102 and the NFET 141 in a source follower arrangement and/or an additional transistor coupled between the second comparator input 104 and the NFET 145 in a source follower arrangement. In this example, a voltage level of an attenuated differential input signal created by the level shifter 116 having two transistors cascaded in a source follower arrangement can be less than a voltage level of an attenuated differential input signal created by the level shifter 116 of FIG. 1 that has one transistor cascaded in a source follower arrangement.

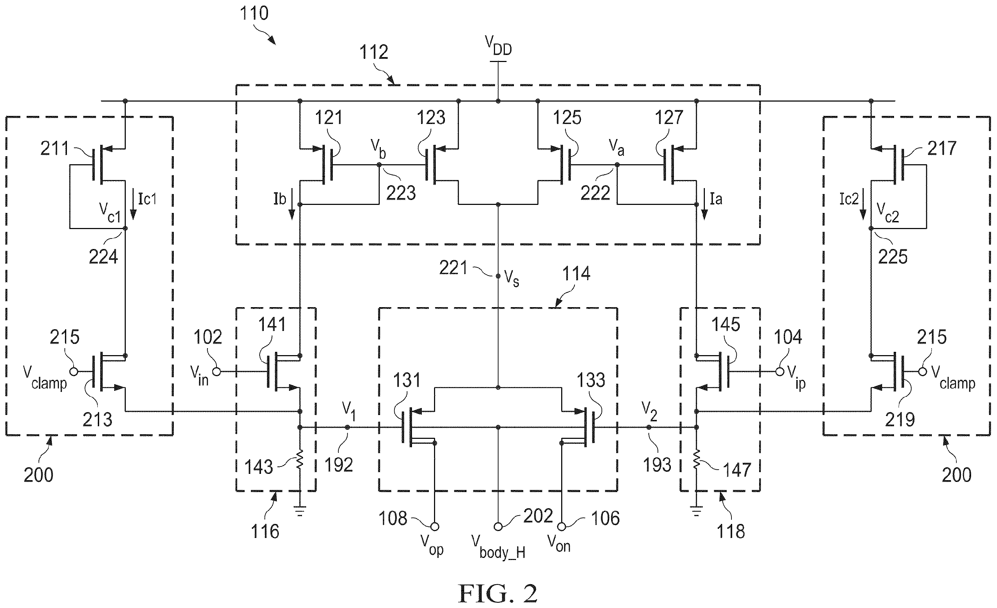

FIG. 2 is a schematic diagram of an example implementation of the high-side input circuit 110. In at least some examples, the high-side input circuit 110 can include a clamp circuit 200 and a high-side body interface 202. The clamp circuit 200 can include a PFET 211, an NFET 213, a clamp interface 215, a PFET 217, and an NFET 219. In an example architecture of the high-side input circuit 110, a body of the PFET 131 is coupled to a body of the PFET 133 and the high-side body interface 202. A source of the PFET 211 is coupled to V_{DD}. A gate of the PFET 211 is coupled to a drain of the PFET 211 and a drain of the NFET 213. A gate of the NFET 213 is coupled to the clamp interface 215. A source of the NFET 213 is coupled to the source of the NFET 141, the first terminal of the resistor 143, and the gate of the PFET 131. A source of the PFET 217 is coupled to V_{DD}. A gate of the PFET 217 is coupled to a drain of the PFET 217 and a drain of the NFET 219. A gate of the NFET 219 is coupled to the clamp interface 215. A source of the NFET 219 is coupled to a source of the NFET 145, the first side of the resistor 147, and the gate of the PFET 133.

As described above, processing of the differential input signal provided to the comparator 100 varies based on a value of V_{cm}. The high-side input circuit 110 can process the differential input signal responsive to V_{cm} exceeding Vt. The low-side input circuit 150 processes the differential input signal responsive to a voltage difference between V_{DD} - Vt and 0 volts exceeding V_{cm}. With reference to FIG. 1, that variation in processing of the differential input signal can involve operation of the active load circuit 155. For example, responsive to providing the differential input signal to the comparator 100, current can flow through the resistor 151 of the low-side input circuit 150. By operation of the active load circuit 155, the current flowing through the high-side input circuit 110 and the low-side input circuit 150 can be combined.

In some instances, operation of the active load circuit 155 can induce cross-leakage current within the high-side input circuit 110. By way of example, a differential input signal can be provided to the first comparator input 102 and the second comparator input 104. V_{cm} of the differential input signal can be below Vt. In this example, V_{cm} of the differential input signal can be below Vₜ responsive to Vᵢₙ and Vᵢₚ both having respective values of about 0 volts or ground. Responsive to providing the differential input signal, a threshold voltage (V_{t,173}) of the NFET 173 can be provided to the respective drains of NFETs 171 and 173, as non-zero current flows through the resistor 151. Because the respective drains of the PFET 131 and the NFET 171 are each coupled to the second comparator output 108, V_{t,173} can also be provided to the drain of the PFET 131. V_{t,173} can also be provided to the drain of the PFET 133 in as much as the respective drains of the PFET 133 and the NFET 173 are each coupled to the first comparator output 106.

Responsive to providing the differential input signal, about 0 volts or ground can be provided to a node 192 coupled to the gate of the PFET 131 and a node 193 coupled to the gate of the PFET 133. The PFET 131 can become active (e.g., turned on) responsive to a voltage (V₁) at the node 192 being less than a voltage (e.g., V_{t,173}) at the second comparator output 108. The PFET 133 can become active (e.g., turned on) responsive to a voltage (V₂) at the node 193 being less than a voltage (e.g., V_{t,173}) at the first comparator output 106. With PFETs 131 and 133 each being active, cross-leakage current can flow between the first comparator output 106 and the second comparator output 108. In effect, a short condition can be created between the first comparator output 106 and the second comparator output 108. The short condition can induce non-linear operation by the comparator 100.

With reference to FIG. 2, the clamp circuit 200 is configured to reduce cross-leakage current within the input pair 114. To that end, the clamp circuit 200 is configured to control V₁ at the node 192 and/or V₂ at the node 193 based on a voltage (V_{clamp}) provided at the clamp interface 215. Responsive to V_{clamp}, the PFET 211 and the NFET 213 can provide a first clamp current (I_{c1}). I_{c1} can flow through the resistor 143 to provide a non-zero voltage (e.g., about 1 volts) at the node 192. Providing the non-zero voltage at the node 192 facilitates clamping V₁ to a voltage level that exceeds a voltage level of Vₒₚ provided at the second comparator output 108. Clamping V₁ to the voltage level that exceeds the voltage level of Vₒₚ is useful to inhibit the PFET 131 from becoming active while Vₜ exceeds V_{cm} of the differential input signal. Stated differently, clamping V₁ to the voltage level that exceeds the voltage level of Vₒₚ facilitates maintaining the PFET 131 inactive (e.g., turned off) while Vt exceeds V_{cm} of the differential input signal.

Responsive to V_{clamp}, the PFET 217 and the NFET 219 can provide a second clamp current (I_{c2}). I_{c2} can flow through the resistor 147 to provide a non-zero voltage (e.g., about 1 volts) at the node 193. Providing the non-zero voltage at the node 193 facilitates clamping V₂ to a voltage level that exceeds a voltage level of Vₒₙ provided at the first comparator output 106. Clamping V₂ to the voltage level that exceeds the voltage level of Vₒₙ is useful to inhibit the PFET 133 from becoming active while Vₜ exceeds V_{cm} of the differential input signal. Stated differently, clamping V₂ to the voltage level that exceeds the voltage level of Vₒₙ facilitates maintaining the PFET 133 inactive (e.g., turned off) while Vt exceeds V_{cm} of the differential input signal.

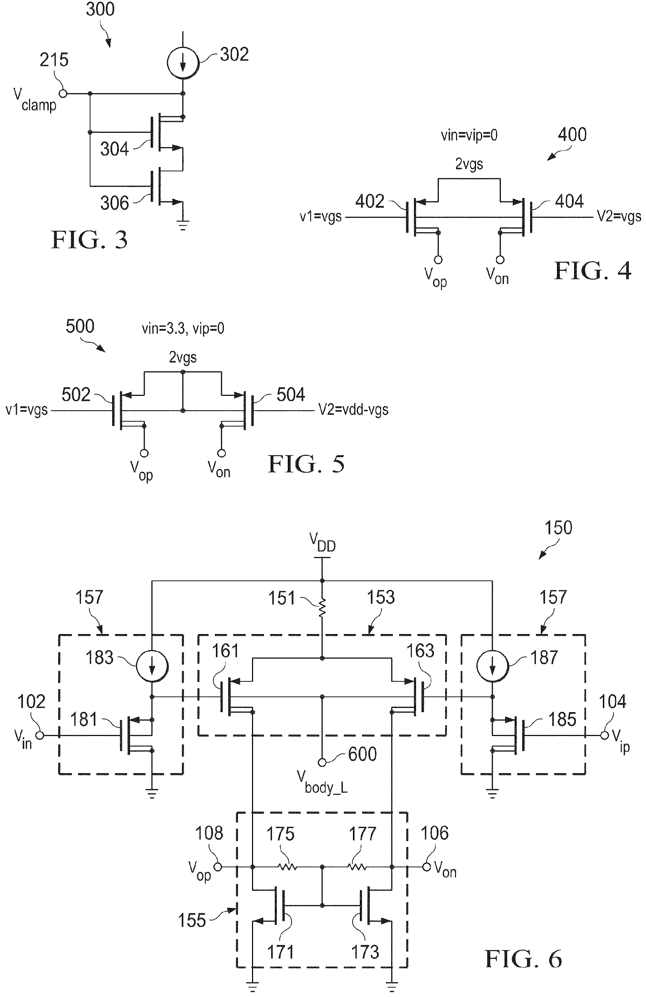

FIG. 3 is a schematic diagram of an example clamp driver circuit 300. In at least one example, the clamp driver circuit 300 is coupled to the clamp interface 215. The clamp driver circuit 300 can include a current source 302, an NFET 304, and an NFET 306. In an example architecture of the clamp driver circuit 300 the NFET 304 is coupled in series with the NFET 306. A drain of the NFET 304 is coupled to the clamp interface 215, a gate of the NFET 304, and a gate of the NFET 306. A source of the NFET 304 is coupled to a drain of the NFET 306. A source of the NFET 306 is coupled to ground. In operation, the current source 302 is configured to sink current to ground.

Various degradation or stress events can negatively impact performance and/or reliability of semiconductor devices, as shown by FIGS. 4-5. FIG. 4 is a diagram of an example degradation or stress event in which a voltage difference between a gate and a body of a transistor or a gate-to-body voltage (V_{gb}) can stress a gate oxide material of the transistor. In FIG. 4, an input pair 400 that includes PFETs 402 and 404. A body or n-well region of the PFET 402 is coupled to V_{DD} and a body or n-well region of the PFET 404. If V_{DD} has a value of about 3.3 volts, a body voltage (V_{b}) of about 3.3 volts can be provided to the respective bodies of PFETs 402 and 404. The input pair 400 can represent an implementation of the input pair 114 in which the respective bodies of PFETs 131 and 133 are tied to V_{DD}.

In operation, a differential input signal can be provided to a differential input of a comparator that includes the input pair 400. V_{cm} of the differential input signal can be about 0 volts with respective values of Vᵢₙ and Vᵢₚ being about 0 volts or ground. Responsive to providing the differential input signal to the differential input, a gate voltage (V_{g}) of Vₜ or about 1 volt can be provided to the respective gates of PFETs 402 and 404. In that instance, PFETs 402 and 404 can each be subject to a V_{gb} of about 2.3 volts with the V_{b} of about 3.3 volts exceeding the V_{g} of Vₜ or about 1 volt. If less than a V_{bd} of gate oxide material forming PFETs 402 and 404, the V_{gb} of about 2.3 volts can induce stress on the gate oxide material. Permanent damage such as rupturing of the gate oxide material can occur if the V_{gb} of about 2.3 volts is greater than or equal to the V_{bd} of the gate oxide material. FIG. 4 represents gate oxide stress that can occur within an input pair of the comparator 100 when V_{b} (e.g., about 3.3 volts) exceeds V_{g} (e.g., about 1 volt) responsive to providing a differential input signal with V_{cm} having a low value (e.g., about 0 volts).

FIG. 5 is a diagram of another example degradation or stress event in which BTI can induce excessive aging of a semiconductor device. In FIG. 5, an input pair 500 includes PFETs 502 and 504. A body or n-well region of the PFET 502 is coupled to a source of the PFET 502, a body or n-well region of the PFET 504, and a source of the PFET 504. The input pair 500 can represent an implementation of the input pair 114 in which the respective bodies of PFETs 131 and 133 are tied to a node (e.g., node 221 of FIG. 2) coupled to the respective sources of PFETs 131 and 133.

In operation, a differential input signal can be applied to a differential input of a comparator that includes the input pair 500. The differential input signal can comprise Vᵢₙ having a value of about 3.3 volts and Vᵢₚ having a value of about 0 volts or ground. Applying the differential input signal to the differential input can provide a gate voltage (V_{g,502}) having a value of Vₜ or about 1 volt to a gate of the PFET 502 and a gate voltage (V_{g,504}) of V_{DD} - Vₜ to a gate of PFET 504. If V_{DD} is about 3.3 volts, V_{g,504} can be about 2.3 volts. Responsive to providing V_{g,502} to the gate of the PFET 502 and V_{g,504} to the gate of PFET 504, a body voltage (V_{b,502}) can be provided to the body of the PFET 502 and a body voltage (V_{b,504}) can be provided to the body of the PFET 504. V_{b,502} and V_{b,504} can each have a value of 2*Vₜ or about 2 volts. While V_{b,504} is less than V_{g,504}, a bias condition exists for PFET 504 that can subject the PFET 504 to positive BTI (PBTI). Subjecting the PFET 504 to PBTI can alter a threshold voltage (V_{t,504}) of the PFET 504. Altering V_{t,504} of the PFET 504 can negatively impact performance of the comparator that includes the input pair 500. For example, an accuracy of the comparator can be reduced by altering V_{t,504} of the PFET 504. FIG. 5 represents BTI-induced aging that can occur within an input pair of the comparator 100 when V_{b} (e.g., about 2 volts) decreases below V_{g} (e.g., about 2.3 volts) responsive to providing a differential input signal with V_{cm} having a high value (e.g., about 3.3 volts).

In at least one example, body bias control can be useful to the comparator 100 for mitigating BTI-induced aging, gate oxide stress, and/or other negative impacts related to degradation or stress events. Body bias control refers to controlling a voltage difference between a source and a body of a transistor or a source-to-body voltage (V_{sb}) to dynamically adjust Vt of the transistor. Body bias control can involve reverse body biasing (RBB) that increases Vt of the transistor and forward body biasing (FBB) that decreases Vt of the transistor. In at least one example, the high-side body interface 202 of FIG. 2 can be useful to implement body bias control within the high-side input circuit 110 of the comparator 100. FIG. 6 is a schematic diagram of an example implementation of the low-side input circuit 150 that includes a low-side body interface 600. In an example architecture of the low-side input circuit 150, the low-side body interface 600 is coupled to a body of the PFET 161 and a body of the PFET 163. In at least one example, the low-side body interface 600 can be useful to implement body bias control within the low-side input circuit 150 of the comparator 100.

With reference to FIG. 2, a current (Iₐ) flowing through the PFET 127 and/or a current (I_{b}) flowing through the PFET 121 can include information about a differential input signal provided at the first comparator input 102 and the second comparator input 104. For example, responsive to the high-side input circuit 110 processing the differential input signal, Iₐ can flow through the resistor 143 to provide V₁ at the node 192 and I_{b} can flow through the resistor 147 to provide V₂ at the node 193. A voltage (Vₐ) provided at a node 222 coupled to the gate of the PFET 127 can be useful to mirror Iₐ. A voltage (V_{b}) provided at a node 223 coupled to the gate of the PFET 121 can be useful to mirror I_{b}.

I_{c1} and/or I_{c2} can also include information about the differential input signal provided at the first comparator input 102 and the second comparator input 104. For example, the clamp circuit 200 can provide, responsive to providing the differential input signal, I_{c1} flowing through the resistor 143 and I_{c2} flowing through the resistor 147, as described above. In this example, I_{c1} flowing through the resistor 143 can also provide V₁ at the node 192 and I_{c2} flowing through the resistor 147 can also provide V₂ at the node 193. A voltage (V_{c1}) provided at a node 224 coupled to the gate and the drain of the PFET 211 can be useful to mirror I_{c1}. A voltage (V_{c2}) provided at a node 225 coupled to the gate and the drain of the PFET 217 can be useful to mirror I_{c2}.

As described above, a gate oxide stress issue can occur within an input pair of the comparator 100 when V_{b} exceeds V_{g} responsive to providing a differential input signal with V_{cm} having a relatively low value (e.g., about 0 volts). BTI-induced aging can also occur within an input pair of the comparator 100 when V_{b} (e.g., about 2 volts) decreases below V_{g} (e.g., about 2.3 volts) responsive to providing a differential input signal with V_{cm} having a high value (e.g., about 3.3 volts). Controlling V_{b} provided to an input pair of the comparator 100 in a manner that tracks V_{cm} variations of a differential input signal can facilitate mitigating such negative impacts of degradation or stress events.

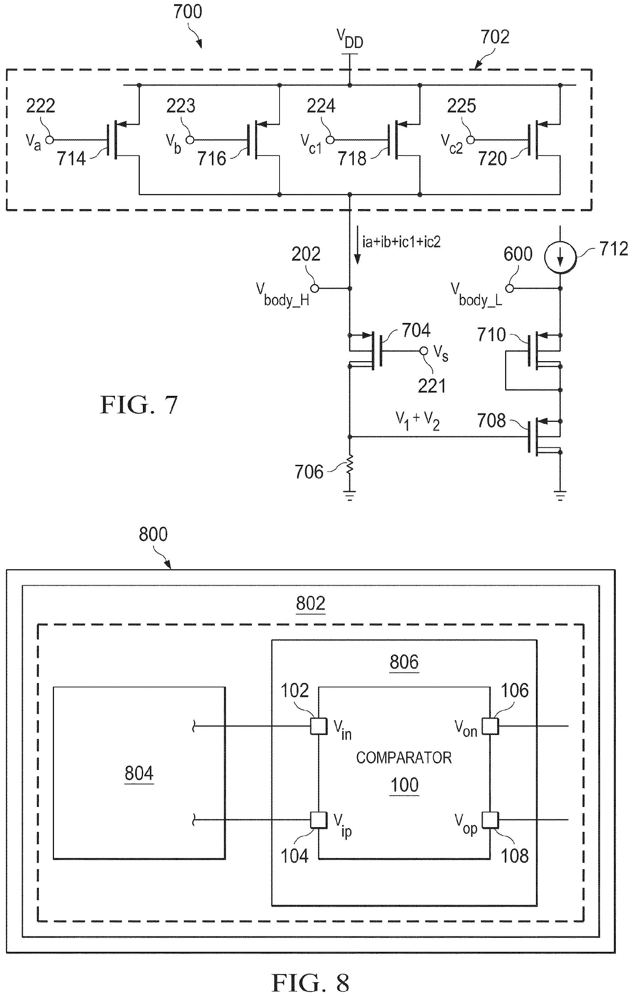

FIG. 7 is a schematic diagram of an example body bias controller 700. In at least some examples, the body bias controller 700 can include a current mirror circuit 702, a PFET 704, a resistor 706, a PFET 708, a PFET 710, and a current source 712. The current mirror circuit 702 can include PFETs 714-720. In an example architecture of the body bias controller 700, each source of PFETs 714 -720 is coupled to VDD. Each drain of PFETs 714-720 is coupled to the high-side body interface 202 and a source of the PFET 704. A gate of the PFET 714 is coupled to the node 222. A gate of the PFET 716 is coupled to the node 223. A gate of the PFET 718 is coupled to the node 224. A gate of the PFET 720 is coupled to the node 225. A gate of the PFET 704 is coupled to the node 221. A drain of the PFET 704 is coupled to a first terminal of the resistor 706 and a gate of the PFET 708. A second terminal of the resistor 706 and a drain of the PFET 708 are each coupled to ground. A source of the PFET 708 is coupled to a drain and a gate of the PFET 710. A source of the PFET 710 is coupled to the low-side body interface 600 and the current source 712.

The body bias controller 700 is configured to control a voltage (V_{body_H}) provided at the high-side body interface 202 and/or a voltage (V_{body_L}) provided at the low-side body interface 600 based on V_{cm} of a differential input signal provided at a differential input of the comparator 100. Information about the differential input signal provided at the first comparator input 102 and the second comparator input 104 forming the differential input can be obtained using the current mirror circuit 702. To that end, the current mirror circuit 702 can mirror Iₐ, I_{b}, I_{c1}, and I_{c2} to the body bias controller 700 using Vₐ at the node 222, V_{b} at the node 223, V_{c1} at the node 224, and V_{c2} at the node 225, respectively. Operation of the PFET 704 can be controlled using Vₛ at the node 221. Iₐ, I_{b}, I_{c1}, and I_{c2} can flow through the resistor 706 responsive to the PFET 704 being active. Responsive to Iₐ, I_{b}, I_{c1}, and I_{c2} flowing through the resistor 706, a voltage at the first terminal of the resistor 706 can be approximately a summation of V₁ at the node 192 and V₂ at the node 193. By operation of the PFET 704, a value of V_{body_H} can be determined according to a maximum of (V₁ + V₂, Vₛ + V_{t,704}), where V_{t,704} denotes a threshold voltage of the PFET 704. In at least one example, a value of V_{body_L} can be determined according to V₁ + V₂ + V _{t,708} + V_{t,710}, where V_{t,708} denotes a threshold voltage of the PFET 708 and V_{t,710} denotes a threshold voltage of the PFET 710.

The body bias controller 700 can facilitate mitigating the negative impacts of degradation or stress events on the input pair 114 and/or the input pair 153 by dynamically adjusting V_{body_H} and/or V_{body_L} in a manner that tracks V_{cm} variations of the differential input signal. For example, the body bias controller 700 can decrease V_{body_H} responsive to V_{cm} of the differential input signal decreasing in value. In this example, decreasing V_{body_H} can facilitate maintaining V_{g} provided to the respective gates of PFETs 131 and 133 above V_{body_H} to reduce gate oxide stress within the input pair 114. As another example, the body bias controller 700 can increase V_{body_H} responsive to V_{cm} of the differential input signal increasing in value. In this example, increasing V_{body_H} can facilitate maintaining V_{g} provided to the respective gates of PFETs 131 and 133 below V_{body_H} to reduce BTI-induced aging within the input pair 114.

FIG. 8 is a block diagram of an example system 800 that includes the comparator 100. At least some implementations of the system 800 are representative of application environments for the comparator 100, such as an automobile, an appliance, a personal electronic device, or other application environments that implement a comparator having a wide CMIR while supporting lower oxide breakdown voltages. In at least some examples, the system 800 includes a printed circuit board 802 having a first semiconductor package 804 and a second semiconductor package 806. The printed circuit board 802 may include one or more conductors (e.g., traces) that couple the first semiconductor package 804 and the second semiconductor package 806. The first semiconductor package 804 and the second semiconductor package 806 can be configured to support different voltage operations (e.g., 1.8-volt operation, 3.3-volt operation, and/or 5-volt operation).

The term "couple" is used throughout the specification. The term may cover connections, communications, or signal paths that enable a functional relationship consistent with this description. For example, if device A generates a signal to control device B to perform an action, in a first example device A is coupled to device B, or in a second example device A is coupled to device B through intervening component C if intervening component C does not substantially alter the functional relationship between device A and device B such that device B is controlled by device A via the control signal generated by device A.

A device that is "configured to" perform a task or function may be configured (e.g., programmed and/or hardwired) at a time of manufacturing by a manufacturer to perform the function and/or may be configurable (or re-configurable) by a user after manufacturing to perform the function and/or other additional or alternative functions. The configuring may be through firmware and/or software programming of the device, through a construction and/or layout of hardware components and interconnections of the device, or a combination thereof.

A circuit or device that is described herein as including certain components may instead be adapted to be coupled to those components to form the described circuitry or device. For example, a structure described as including one or more semiconductor elements (such as transistors), one or more passive elements (such as resistors, capacitors, and/or inductors), and/or one or more sources (such as voltage and/or current sources) may instead include only the semiconductor elements within a single physical device (e.g., a semiconductor die and/or integrated circuit (IC) package) and may be adapted to be coupled to at least some of the passive elements and/or the sources to form the described structure either at a time of manufacture or after a time of manufacture, for example, by an end-user and/or a third-party.

While certain components may be described herein as being of a particular process technology, these components may be exchanged for components of other process technologies. Circuits described herein are reconfigurable to include the replaced components to provide functionality at least partially similar to functionality available prior to the component replacement. Components shown as resistors, unless otherwise stated, are generally representative of any one or more elements coupled in series and/or parallel to provide an amount of impedance represented by the shown resistor. For example, a resistor or capacitor shown and described herein as a single component may instead be multiple resistors or capacitors, respectively, coupled in parallel between the same nodes. For example, a resistor or capacitor shown and described herein as a single component may instead be multiple resistors or capacitors, respectively, coupled in series between the same two nodes as the single resistor or capacitor.

Uses of the phrase "ground voltage potential" in the foregoing description include a chassis ground, an Earth ground, a floating ground, a virtual ground, a digital ground, a common ground, and/or any other form of ground connection applicable to, or suitable for, the teachings of this description. Unless otherwise stated, "about," "approximately," or "substantially" preceding a value means +/- 10 percent of the stated value. Modifications are possible in the described examples, and other examples are possible within the scope of the claims.

## Claims

1. A circuit (110), comprising:
first and second input terminals (102, 104) configured to collectively receive a differential input signal;
first and second output terminals (106, 108);
first and second transistors (141, 145) having respective first terminals, respective second terminals, and respective third terminal, the first terminals respectively coupled to the first and second input terminals (106, 108);
third and fourth transistors (131, 133) having respective first terminals, respective second terminals, respective third terminals, and respective bodies, the first terminals respectively coupled to the respective second terminals of the first and second transistors (141, 145), the third terminals respectively coupled to the first and second output terminals (106, 108), and the bodies respectively coupled to a first body interface (V_{body_H}); and
a body bias controller (700) configured to provide a first body voltage to the first body interface (V_{body_H}) based on a common mode voltage of the differential input signal.

2. The circuit of claim 1, further comprising:
fifth and sixth transistors (181, 185) having respective first terminals and respective second terminals, the first terminals respectively coupled to the first and second input terminals (106, 108); and
seventh and eighth transistors (161, 163) having respective first terminals, respective second terminals, respective third terminals, and respective bodies, the first terminals respectively coupled to the respective second terminals of the fifth and sixth transistors (181, 185), the third terminals respectively coupled to the first and second output terminals (106, 108), and the bodies respectively coupled to a second body interface (V_{body_L}),
wherein the body bias controller (700) is further configured to provide a second body voltage to the second body interface (V_{body_L}) based on the common mode voltage of the differential input signal.

3. The circuit of claim 2, wherein the body bias controller (700) comprises:
a ninth transistor (704) having a first terminal, a second terminal, and a third terminal, the first terminal coupled to the respective second terminals of the third and fourth transistors (131, 133), and the second terminal coupled to the first body interface (V_{body_H}).

4. The circuit of claim 3, wherein the body bias controller (700) further comprises:
a current mirror circuit (702) coupled to the first body interface (V_{body_H}).

5. The circuit of claim 4, wherein the current mirror circuit (702) is configured to provide a current based on respective currents through the first and second transistors (141, 145).

6. The circuit of claim 4, wherein the current mirror circuit (702) comprises at least one transistor (714, 716, 718, 720) having a first terminal, a second terminal, and a third terminal, the second terminal coupled to a voltage supply terminal, and the third terminal coupled to the first body interface (V_{body_H}).

7. The circuit of claim 3, wherein the body bias controller (700) further comprises:
a resistor (706) having a first terminal and a second terminal, the first terminal coupled to the third terminal of the ninth transistor (704), and the second terminal coupled to ground.

8. The circuit of claim 7, wherein the body bias controller (700) further comprises:
a tenth transistor (710) having a first terminal, a second terminal, and a third terminal, the first terminal coupled to the third terminal of the tenth transistor (710), and the second terminal coupled to the second body interface (V_{body_L}).

9. The circuit of claim 8, wherein the body bias controller (700) further comprises:
an eleventh transistor (708) having a first terminal, a second terminal, and a third terminal, the first terminal coupled to the third terminal of the ninth transistor (704), the second terminal coupled to third terminal of the tenth transistor (710), the third terminal coupled to ground.

10. The circuit of claim 8, wherein the body bias controller (700) further comprises:
a current source (712) coupled to the second body interface (V_{body_L}).

11. The circuit of claim 1, further comprising:
a twelfth transistor (121) having a first terminal, a second terminal, and a third terminal, the first and third terminals coupled to the third terminal of the first transistor (141), and the second terminal coupled to a voltage supply terminal;
a thirteenth transistor (123) having a first terminal, a second terminal, and a third terminal, the first terminal coupled to the third terminal of the first transistor (141), the second terminal coupled to the voltage supply terminal, and the third terminal coupled to the second terminal of the third transistor (131);
a fourteenth transistor (127) having a first terminal, a second terminal, and a third terminal, the first and third terminals coupled to the third terminal of the second transistor (145), and the second terminal coupled to the voltage supply terminal; and
a fifteenth transistors (125) having a first terminal, a second terminal, and a third terminal, the first terminal coupled to the third terminal of the second transistor (145), the second terminal coupled to the voltage supply terminal, and the third terminal coupled to the second terminal of the fourth transistor (133).

12. The circuit of claim 1, further comprising:
sixteenth and seventeenth transistors (213, 219) having respective first terminals, respective second terminals, and respective third terminals, the first terminals respectively coupled to a clamp voltage (215), the second terminals respectively coupled to the respective first terminals of the third and fourth transistors (131, 133).

13. The circuit of claim 12, further comprising:
eighteenth and nineteenth transistors (211, 217) having respective first terminals, respective second terminals, and respective third terminals, the first terminals and third terminals respectively coupled to the respective third terminals of the sixteenth and seventeenth transistors (213, 219), and the second terminals respectively coupled to a voltage supply terminal.

14. The circuit of claim 1, wherein the first and second transistors (141, 145) are n-channel field-effect transistors, and the first, second, and third terminals of the first and second transistors (141, 145) are respective gate, source, and drain terminals of the first and second transistors (141, 145), and wherein the third and fourth transistors (131, 133) are p-channel field-effect transistors, and the first, second, and third terminals of the third and fourth transistors (131, 133) are respective gate, source, and drain terminals of the third and fourth transistors (131, 133).
